# EUROPÄISCHE PATENTANMELDUNG

(11) **EP 4 715 218 A1**
(43) Veröffentlichungstag der Anmeldung: **25.03.2026**
(21) Anmeldenummer: 25198520.6
(22) Anmeldetag: 27.08.2025
(51) Int. Cl.: F04D 25/16, F04D 29/60, F04D 29/66

(54) **VERSTEIFUNGSVORRICHTUNG**

(30) Priorität: 19.09.2024 DE 102024127092
(71) Anmelder: ebm-papst Mulfingen GmbH & Co. KGaA & Co. KG, 74673 Mulfingen (DE)
(72) Erfinder: Sauer, Thomas, 97980 Bad Mergentheim (DE); Smetana, Tomas, 91074 Herzogenaurach (DE)
(74) Vertreter: Staeger & Sperling Partnerschaftsgesellschaft mbB

(57) **Zusammenfassung**

Die Erfindung betrifft eine Versteifungsvorrichtung (10) zur Versteifung parallel angeordneter Ventilatoren (100) mit einem Grundkörper (1),
wobei an dem Grundkörper (1) ein erstes Befestigungselement (2) zur Befestigung an einer Aufnahmestruktur (15) eines der Ventilatoren (100) ausgebildet ist,
wobei an dem Grundkörper (1) ein zweites Befestigungselement (3) zur Befestigung an einer Aufnahmestruktur (15) eines weiteren, insbesondere unmittelbar benachbart angeordneten, Ventilators (100) ausgebildet ist,
wobei der Grundkörper (1) ein Toleranzausgleichsmittel (4) zur, insbesondere stufenlosen, Anpassung einer Längserstreckung der Versteifungsvorrichtung (10) aufweist, derart, dass in einem montierten Zustand eine Steifigkeit der durch die Versteifungsvorrichtung (10) verbundenen Ventilatoren (100) erhöhbar ist.

## Beschreibung

Die Erfindung betrifft eine Versteifungsvorrichtung zur Versteifung parallel angeordneter Ventilatoren mit einem, insbesondere stabförmigen und/oder trägerförmigen und/oder strebenförmigen, Grundkörper.

Beim Betrieb von mehreren Ventilatoren in paralleler Anordnung, z. B. in einem Klimakastengerät (Air Handling Unit/AHU), können je nach mechanischer Ausführung Resonanzfrequenzen des mechanischen Aufbaus innerhalb des Drehzahlbereichs der Ventilatoren liegen. Durch die Art der Aufhängung des Ventilators z.B. über eine Haltespinne, ergibt sich ein leicht anzuregender schwingungsfähiger Aufbau, der zusammen mit der mechanischen Haltekonstruktion zu Resonanzfrequenzen führt. Diese Resonanzfrequenzen werden durch die Unwucht eines oder mehrerer Ventilatoren angeregt und können zu unzulässig hohen Schwingungsbelastungen für den einzelnen Ventilator führen. Dadurch ergibt sich ein Frühausfall des Ventilators.

Ferner wird ein Klimakastengerät typischerweise genau auf den Anwendungsfall ausgelegt. Auf diese Weise sind die Abmessungen und damit auch die auftretenden Resonanzfrequenzen stark unterschiedlich.

Der Erfindung liegt deshalb die Aufgabe zugrunde, die vorgenannten Nachteile zu überwinden und eine Versteifungsvorrichtung zur Versteifung parallel angeordneter Ventilatoren bereitzustellen, welche an einen individuellen Abstand zwischen Ventilatoren anpassbar ist sowie einfach und ohne aufwändige Hilfsmittel nachrüstbar ist.

Diese Aufgabe wird durch die Merkmalskombination gemäß Patentanspruch 1 gelöst.

Der Grundgedanke der vorliegenden Erfindung ist, die Resonanzfrequenz der parallel angeordneten Ventilatoren in höhere Drehzahlbereiche zu verschieben, mit dem Ziel die Resonanzfrequenz außerhalb des vorbestimmten Drehzahlbereichs der Ventilatoren zu verschieben. Dies erfolgt mittels einer, vorzugsweise in einer Ebene in Höhe der Motoraufhängung des Ventilators, an der, vorzugsweise spinnenförmigen, Aufnahmestruktur des Ventilators angeordneten, vorzugsweise verstrebungsartigen, Versteifungsvorrichtung, welche durch eine einfache Befestigung, insbesondere einer Klemmung und/oder einer Verrastung, sowie einer Längenanpassung mittels eines Toleranzausgleichsmittels universell einsetzbar ist. Dabei ist die Versteifungsvorrichtung verstrebungsartig zwischen den beiden Ventilatoren angeordnet.

Erfindungsgemäß wird daher eine Versteifungsvorrichtung zur Versteifung parallel angeordneter Ventilatoren mit einem, insbesondere stabförmigen und/oder trägerförmigen und/oder strebenförmigen, Grundkörper vorgeschlagen. Ferner ist an dem Grundkörper ein erstes Befestigungselement zur Befestigung an einer Aufnahmestruktur, insbesondere einer Halterung, einem Gehäuse, einem Träger, einem Rahmen und/oder einem Aufnahmebügel, vorzugsweise für einen Ventilatormotor, eines der Ventilatoren ausgebildet. Darüber hinaus ist an dem Grundkörper ein zweites Befestigungselement zur Befestigung an einer Aufnahmestruktur, insbesondere einer Halterung, einem Gehäuse, einem Träger, einem Rahmen und/oder einem Aufnahmebügel, vorzugsweise für einen Ventilatormotor, eines weiteren unmittelbar benachbart angeordneten Ventilators ausgebildet. Des Weiteren weist der Grundkörper ein Toleranzausgleichsmittel zur stufenlosen Anpassung einer Längserstreckung der Versteifungsvorrichtung auf, derart, dass in einem montierten Zustand eine Steifigkeit der durch die Versteifungsvorrichtung verbundenen Ventilatoren erhöhbar ist.

In einer vorteilhaften Ausführungsvariante ist vorgesehen, dass das erst Befestigungselement an einem ersten längsseitigen Ende des Grundkörpers und/oder das zweite Befestigungselement an einem zweiten längsseitigen Ende des Grundkörpers ausgebildet ist.

Vorzugsweise ist die Versteifungsvorrichtung derart ausgebildet, dass das Toleranzausgleichsmittel eine Gewindespindel oder ein, insbesondere fixierbarer, Teleskopmechanismus oder ein, insbesondere fixierbares, Schienensystem ist.

In einem Ausführungsbeispiel der Erfindung ist vorgesehen, dass der Grundkörper in einen ersten Grundkörperteil und einen zweiten Grundkörperteil geteilt ausgebildet ist. Dabei weist der erste Grundkörperteil und/oder der zweite Grundkörperteil zumindest in einem Verbindungsbereich ein Gewinde auf und/oder ist bolzengewindeförmig oder schraubenförmig ausgebildet. Ferner ist das Toleranzausgleichsmittel eine Schraubenmutter, insbesondere Langmutter, und/oder eine Hülse mit einem Innengewinde, welche den ersten Grundkörperteil und den zweiten Grundkörperteil miteinander verbindet.

Des Weiteren ist eine Ausführung günstig, bei welcher das erste Befestigungselement und/oder das zweite Befestigungselement ein Rastmittel, insbesondere ein Rasthaken oder ein Clip oder eine Klammer oder ein Bügel, ist.

Erfindungsgemäß wird ferner ein System mit zumindest zwei parallel angeordneten Ventilatoren vorgeschlagen, bei welchem zumindest zwischen zwei der parallel angeordneten Ventilatoren eine Versteifungsvorrichtung gemäß der vorstehenden Offenbarung vorgesehen ist, derart, dass eine Steifigkeit der durch die entsprechende Versteifungsvorrichtung verbundenen Ventilatoren erhöht ist.

In einem vorteilhaften Ausführungsbeispiel ist vorgesehen, dass eine Vielzahl von parallel angeordneten Ventilatoren vorgesehen ist und zwischen benachbarten Ventilatoren jeweils zumindest eine Versteifungsvorrichtung gemäß der vorstehenden Offenbarung angeordnet ist.

In einer weiteren vorteilhaften Variante ist erfindungsgemäß vorgesehen, dass die Versteifungsvorrichtungen in Längsrichtung der Ventilatoren parallel, vorzugsweise parallel zur Längsrichtung der Ventilatoren, und/oder versetzt zueinander angeordnet sind.

In einem alternativen Ausführungsbeispiel ist erfindungsgemäß vorgesehen, dass die Versteifungsvorrichtungen in Längsrichtung der Ventilatoren abwechselnd mit einer positiven Steigung und einer negativen Steigung an benachbarten Ventilatoren angeordnet sind.

Das erfindungsgemäße System ist in einer Ausführungsvariante ausgebildet, dass zumindest an einem Ventilator, welcher in einer Reihe der parallel angeordneten Ventilatoren an einem Ende der Reihe angeordnet ist, eine Versteifungsvorrichtung gemäß der vorstehenden Offenbarung angeordnet ist, welche mit dem zweiten Befestigungselement an einer Wand und/oder einem Träger und/oder einer Montagefläche der Ventilatoren befestigt ist.

Die vorstehend offenbarten Merkmale sind beliebig kombinierbar, soweit dies technisch möglich ist und diese nicht im Widerspruch zueinander stehen.

Andere vorteilhafte Weiterbildungen der Erfindung sind in den Unteransprüchen gekennzeichnet bzw. werden nachstehend zusammen mit der Beschreibung der bevorzugten Ausführung der Erfindung anhand der Figuren näher dargestellt. Es zeigen:
- Fig. 1: eine perspektivische Ansicht einer Versteifungsvorrichtung;
- Fig. 2: eine schematische Ansicht eines Systems; und
- Fig. 3: eine schematische Ansicht eines weiteren Systems.

Die Figuren sind beispielhaft schematisch. Gleiche Bezugszeichen in den Figuren weisen auf gleiche funktionale und/oder strukturelle Merkmale hin.

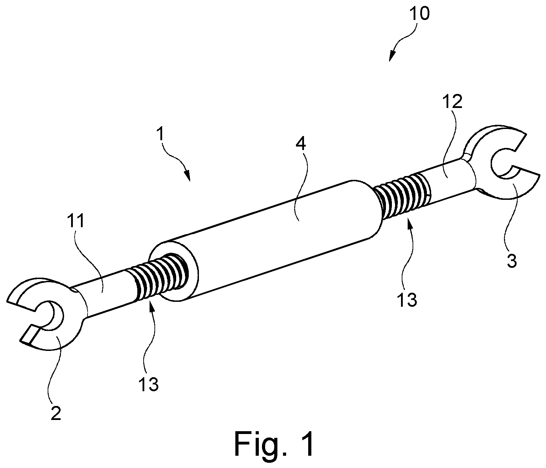

In Figur 1 ist eine perspektivische Ansicht einer Versteifungsvorrichtung 10 zur Versteifung parallel angeordneter Ventilatoren 100 mit einem stabförmigen Grundkörper 1 dargestellt.

An dem Grundkörper 1 ist ein erstes Befestigungselement 2 zur Befestigung an einer Aufnahmestruktur 15 eines der Ventilatoren 100 ausgebildet. Ferner ist an dem Grundkörper 1 ein zweites Befestigungselement 3 zur Befestigung an einer Aufnahmestruktur 15 eines weiteren, unmittelbar benachbart angeordneten, Ventilators 100 ausgebildet. Das erste Befestigungselement 2 und das zweite Befestigungselement 3 sind jeweils ein Rastmittel, insbesondere ein Rasthaken. Des Weiteren sind das erste Befestigungselement 2 an einem ersten längsseitigen Ende des Grundkörpers 1 und das zweite Befestigungselement 3 an einem zweiten längsseitigen Ende des Grundkörpers 1 ausgebildet.

Darüber hinaus weist der Grundkörper 1 ein Toleranzausgleichsmittel 4 zur stufenlosen Anpassung einer Längserstreckung der Versteifungsvorrichtung 10 auf, derart, dass in einem montierten Zustand eine Steifigkeit der durch die Versteifungsvorrichtung 10 verbundenen Ventilatoren 100 erhöhbar ist.

Außerdem ist der Grundkörper 1 in einen ersten Grundkörperteil 11 und einen zweiten Grundkörperteil 12 geteilt ausgebildet. Dabei weisen der erste Grundkörperteil 11 und der zweite Grundkörperteil 12 zumindest in einem Verbindungsbereich ein Gewinde 13 auf und/oder sind bolzengewindeförmig oder schraubenförmig ausgebildet. Dabei ist das Toleranzausgleichsmittel 4 eine Schraubenmutter, insbesondere Langmutter, welche den ersten Grundkörperteil 11 und den zweiten Grundkörperteil 12 miteinander verbindet.

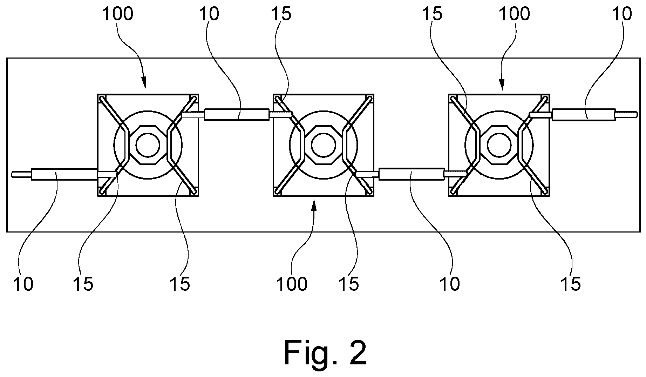

Figur 2 zeigt eine schematische Ansicht eines Systems mit drei parallel angeordneten Ventilatoren 100, bei welchem zwischen benachbarten Ventilatoren 10 der parallel angeordneten Ventilatoren 100 jeweils eine Versteifungsvorrichtung 10 gemäß einem der vorstehenden Offenbarung vorgesehen ist, derart, dass eine Steifigkeit der durch die entsprechende Versteifungsvorrichtung 10 verbundenen Ventilatoren 100 erhöht ist.

Dabei sind die Versteifungsvorrichtungen 10 in Längsrichtung der Ventilatoren 100 parallel zur Längsrichtung der Ventilatoren 100 und versetzt zueinander angeordnet.

Des Weiteren ist an beiden Ventilatoren 100, welche in einer Reihe der parallel angeordneten Ventilatoren 100 an einem Ende der Reihe angeordnet sind, eine Versteifungsvorrichtung 10 gemäß der vorstehenden Offenbarung angeordnet, welche mit dem zweiten Befestigungselement 3 an einer Wand und/oder einem Träger und/oder einer Montagefläche der Ventilatoren 100 befestigt ist.

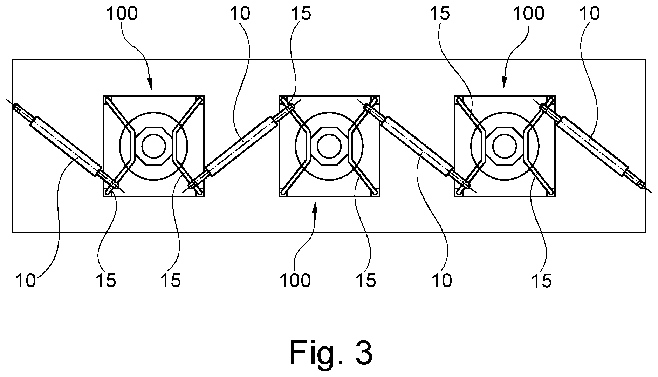

In Figur 3 ist eine schematische Ansicht eines weiteren Systems mit drei parallel angeordneten Ventilatoren 100 dargestellt, bei welchem zwischen benachbarten Ventilatoren 10 der parallel angeordneten Ventilatoren 100 jeweils eine Versteifungsvorrichtung 10 gemäß einem der vorstehenden Offenbarung vorgesehen ist, derart, dass eine Steifigkeit der durch die entsprechende Versteifungsvorrichtung 10 verbundenen Ventilatoren 100 erhöht ist. Nachdem das in Figur 3 dargestellte weitere System im Wesentlichen die Merkmale des in Figur 2 dargestellten Systems aufweist, wird nachfolgend lediglich auf unterschiedliche Merkmale eingegangen.

Entsprechend Figur 3 sind die Versteifungsvorrichtungen 10 in Längsrichtung der Ventilatoren 100 abwechselnd mit einer positiven Steigung und einer negativen Steigung an benachbarten Ventilatoren 100 angeordnet sind.

Die Erfindung beschränkt sich in ihrer Ausführung nicht auf die vorstehend angegebenen bevorzugten Ausführungsbeispiele. Vielmehr ist eine Anzahl von Varianten denkbar, welche von der dargestellten Lösung auch bei grundsätzlich anders gearteten Ausführungen Gebrauch macht.

## Patentansprüche

1. Versteifungsvorrichtung (10) zur Versteifung parallel angeordneter Ventilatoren (100) mit einem Grundkörper (1),
wobei an dem Grundkörper (1) ein erstes Befestigungselement (2) zur Befestigung an einer Aufnahmestruktur (15) eines der Ventilatoren (100) ausgebildet ist,
wobei an dem Grundkörper (1) ein zweites Befestigungselement (3) zur Befestigung an einer Aufnahmestruktur (15) eines weiteren unmittelbar benachbart angeordneten Ventilators (100) ausgebildet ist,
wobei der Grundkörper (1) ein Toleranzausgleichsmittel (4) zur stufenlosen Anpassung einer Längserstreckung der Versteifungsvorrichtung (10) aufweist, derart, dass in einem montierten Zustand eine Steifigkeit der durch die Versteifungsvorrichtung (10) verbundenen Ventilatoren (100) erhöhbar ist.

2. Versteifungsvorrichtung (10) gemäß Anspruch 1, wobei das erst Befestigungselement (2) an einem ersten längsseitigen Ende des Grundkörpers (1) und/oder das zweite Befestigungselement (3) an einem zweiten längsseitigen Ende des Grundkörpers (1) ausgebildet ist.

3. Versteifungsvorrichtung (10) gemäß Anspruch 1 oder 2, wobei das Toleranzausgleichsmittel (4) eine Gewindespindel oder ein, insbesondere fixierbarer, Teleskopmechanismus oder ein, insbesondere fixierbares, Schienensystem ist.

4. Versteifungsvorrichtung (10) gemäß Anspruch 1 oder 2, wobei der Grundkörper (1) in einen ersten Grundkörperteil (11) und einen zweiten Grundkörperteil (12) geteilt ausgebildet ist, wobei der erste Grundkörperteil (11) und/oder der zweite Grundkörperteil (12) zumindest in einem Verbindungsbereich ein Gewinde (13) aufweist und/oder bolzengewindeförmig oder schraubenförmig ausgebildet ist, wobei das Toleranzausgleichsmittel (4) eine Schraubenmutter, insbesondere Langmutter, und/oder ein Hülse mit einem Innengewinde ist, welche den ersten Grundkörperteil (11) und den zweiten Grundkörperteil (12) miteinander verbindet.

5. Versteifungsvorrichtung (10) gemäß einem der vorhergehenden Ansprüche, wobei das erste Befestigungselement (2) und/oder das zweite Befestigungselement (3) ein Rastmittel, insbesondere ein Rasthaken oder ein Clip oder eine Klammer oder ein Bügel, ist.

6. System mit zumindest zwei parallel angeordneten Ventilatoren (100), wobei zumindest zwischen zwei der parallel angeordneten Ventilatoren (100) eine Versteifungsvorrichtung (10) gemäß einem der vorhergehenden Ansprüche vorgesehen ist, derart, dass eine Steifigkeit der durch die entsprechende Versteifungsvorrichtung (10) verbundenen Ventilatoren (100) erhöht ist.

7. System gemäß Anspruch 6, wobei eine Vielzahl von parallel angeordneten Ventilatoren (100) vorgesehen ist, wobei zwischen benachbarten Ventilatoren (100) jeweils zumindest eine Versteifungsvorrichtung (10) gemäß den Ansprüchen 1 bis 5 angeordnet ist.

8. System gemäß Anspruch 6 oder 7, wobei die Versteifungsvorrichtungen (10) in Längsrichtung der Ventilatoren (100) parallel, vorzugsweise parallel zur Längsrichtung der Ventilatoren (100), und/oder versetzt zueinander angeordnet sind.

9. System gemäß Anspruch 6 oder 7, wobei die Versteifungsvorrichtungen (10) in Längsrichtung der Ventilatoren (100) abwechselnd mit einer positiven Steigung und einer negativen Steigung an benachbarten Ventilatoren (100) angeordnet sind.

10. System gemäß einem der vorhergehenden Ansprüche 6 bis 9, wobei zumindest an einem Ventilator (100), welcher in einer Reihe der parallel angeordneten Ventilatoren (100) an einem Ende der Reihe angeordnet ist, eine Versteifungsvorrichtung (10) gemäß einem der Ansprüche 1 bis 5 angeordnet ist, welche mit dem zweiten Befestigungselement (3) an einer Wand und/oder einem Träger und/oder einer Montagefläche der Ventilatoren (100) befestigt ist.
